# EUROPEAN PATENT APPLICATION

(11) **EP 4 783 813 A1**
(43) Date of publication of application: **29.07.2026**
(21) Application number: 26153797.1
(22) Date of filing: 23.01.2026
(51) Int. Cl.: H10P 72/10

(54) **WAFER CARRIER**

(30) Priority: 27.01.2025 US 202563750138 P
(71) Applicant: ASM IP Holding B.V., 1322 AP Almere (NL)
(72) Inventor: HERBSCHLEB, Cornelis, 1322 AP Almere (NL); OOSTERLAKEN, Theodorus G.M., 1322 AP Almere (NL); RONNER, Gijsbert, 1322 AP Almere (NL); BOONSTRA, Klaas P., 1322 AP Almere (NL); JDIRA, Lucian, 1322 AP Almere (NL)
(74) Representative: V.O.

(57) **Abstract**

A wafer boat is disclosed. The wafer boat comprises two side rods and at least one back rod, the rods extending substantially vertically between a top member and a bottom member. The rods comprise vertically spaced apart support formed at corresponding heights, each support extending away from the respective boat rods towards a central axis of the wafer boat. Each support has a wafer support surface for contacting a wafer, the wafer support surface being a polished surface, and each wafer support surface is terminated by two rounded corners.

## Description

### FIELD

The present disclosure relates generally to the field of semiconductor processing methods, and associated structures and apparatus, and to the field of device and integrated circuit manufacture. More particularly the present disclosure generally relates to a wafer boat for supporting a plurality of semiconductor wafers.

### BACKGROUND

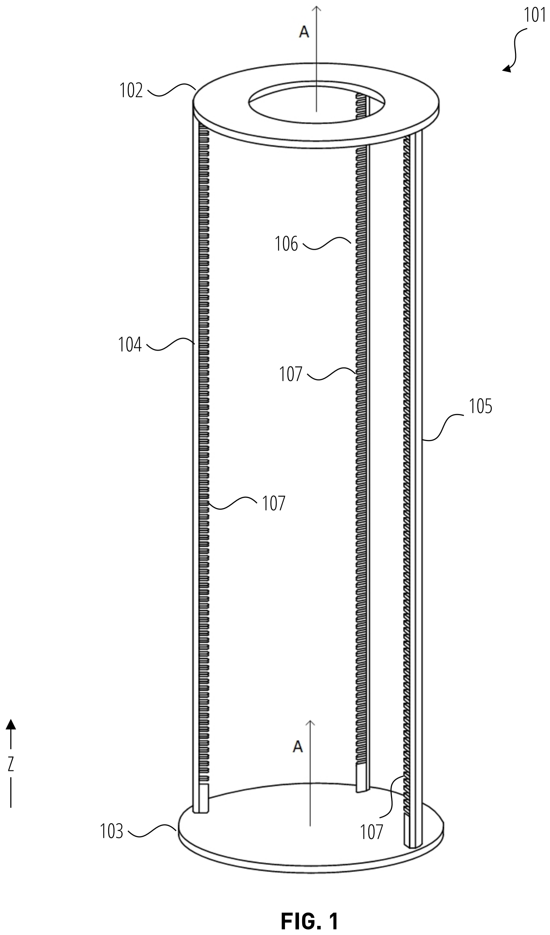

In vertical furnaces used for semiconductor wafer processing, a wafer boat may be used for accommodating a plurality of vertically spaced apart wafers. Typically, as shown in FIG. 1, a wafer boat comprises three or more vertical rods which extend between a top member and a bottom member. In the example of FIG. 1, three rods are shown: two side rods and one back rod. In the rods, vertically spaced apart recesses are formed at corresponding heights, facing inwardly (i.e. generally towards a central axis of the wafer boat). Each recess serves as a support arranged for engaging a circumferential side portion of a wafer, and recesses at a same height define a wafer accommodation for receiving and supporting a wafer in a substantially horizontal orientation. Wafers can be inserted into and removed from the boat at an open side of the boat, opposite the back rod.

High contact stress between a wafer and a support can result in particle formation along wafer edges in the vicinity of the boat rods. This can cause contamination of wafers and reduce the preventive maintenance lifetime.

Any discussion, including discussion of problems and solutions, set forth in this section, has been included in this disclosure solely for the purpose of providing a context for the present disclosure, and should not be taken as an admission that any or all of the discussion was known at the time the invention was made or otherwise constitutes prior art.

### BRIEF SUMMARY

This summary introduces a selection of concepts in a simplified form, which are described in further detail below. This summary is not intended to necessarily identify key features or essential features of the claimed subject matter, nor is it intended to be used to limit the scope of the claimed subject matter.

According to a first aspect of the present invention, there is provided a wafer boat comprising two side rods and at least one back rod, the rods extending substantially vertically between a top member and a bottom member, the rods comprising vertically spaced apart supports formed at corresponding heights, each support extending away from the respective boat rods towards a central axis of the wafer boat, wherein each support has a wafer support surface for contacting a wafer, the wafer support surface being a polished surface, and wherein each wafer support surface is terminated by two rounded corners.

By providing the polished wafer support surface, contact stress on a wafer supported on the wafer support surface is reduced, which may help to reduce particle generation and/or damage to the wafer. Reducing the rate of particle generation may increase the duration between occurrence preventive maintenance, which can help to increase throughput of a semiconductor processing apparatus using a boat according to embodiments of the present invention.

The wafer support surface may comprise a constant width portion between the rounded corners and the respective boat rod.

The rounded corners of the wafer support surfaces of the side rods may each formed by an arc. The two arcs may have different arc lengths. One of the arc lengths may be between 30% and 70% of the other arc length. The rounded corner having the smaller arc length may connect to a second straight edge portion at a side edge of the support, wherein the second straight edge portion is at an angle to the edge of the constant width portion. By providing rounded corners with different arc lengths along with the second straight edge portion, contact stress between a wafer and support may be reduced.

The centres of the two arcs may be displaced relative to each other.

The rounded corners may be connected to each other by a first straight edge portion at a front edge of the support.

The rounded corners may meet directly at a front edge of the support.

The rounded corners may have substantially the same radius of curvature.

The radius of curvature may be between 1mm and 15mm. The radius of curvature may be between 3mm and 8mm.

The wafer support surface may extend from the rod in a planar manner, being delimited by a back edge, first and second side edges, and front edge, each edge being in the same plane and the front edge being closer to the central axis of the boat than the back edge is. The wafer support surface may be not symmetrical with respect to reflection about an axis in the plane of the wafer support surface, the axis bisecting the back edge.

The wafer support surface may have a root-mean-square roughness of less than 1nm.

Surfaces of the boat other than the wafer support surface may have a root mean square roughness of more than 1 µm.

The wafer support surface may have an edge which is rounded off.

The rounded off edge may have a radius of curvature of between 0.5 mm and 10 mm.

A radius of curvature from the rounded off edge to the wafer support surface may be larger than the radius of curvature of the rounded off edge. This may help to provide a smooth transition from the rounded off edge to the wafer support surface.

The boat may comprise silicon, silicon carbide, and/or quartz.

Other technical features may be readily apparent to one skilled in the art from the following figures, descriptions, and claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWINGS

Certain embodiments of the present invention will now be described, by way of example, with reference to the accompanying drawings, in which:
FIG. 1 is a schematic perspective view of a wafer boat according to embodiments of the present invention;
FIG. 2 is a schematic plan view of a wafer support surface according to embodiments of the present invention having two rounded corners of equal arc length;
FIG. 3 is a further schematic plan view of a wafer support surface according to embodiments of the present invention having two rounded corners of equal arc length;
FIG. 4 is a schematic plan view of a wafer support surface according to embodiments of the present invention having two rounded corners of unequal arc length;
FIG. 5 is a further schematic plan view of a wafer support surface according to embodiments of the present invention having two rounded corners of unequal arc length;
FIG. 6 is a schematic cross-section of a boat according to embodiments of the present invention taken in a plane perpendicular to the central axis of the boat;
FIG. 7 is a schematic side view of a section of a boat rod of a boat according to embodiments of the present invention, viewed along a direction perpendicular to the central axis of the boat.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

The description of exemplary embodiments of methods and compositions provided below is merely exemplary and is intended for purposes of illustration only. The following description is not intended to limit the scope of the disclosure or the claims. Moreover, recitation of multiple embodiments having indicated features or steps is not intended to exclude other embodiments having additional features or steps or other embodiments incorporating different combinations of the stated features or steps.

Where in the present disclosure two or more elements are referred to as being "in fluid communication", it is meant that a fluid such as a gas or liquid or mixture thereof can flow between the elements, in one or both directions. The fluid communication may be achieved, for example, by means of a gas line, tube, pipe, inlet, outlet, or any combination thereof. The fluid communication may be interruptible; for example, a valve or other flow control element may be present.

In this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, etc. in some embodiments. Further, in this disclosure, the terms "including," "constituted by" and "having" can refer independently to "typically or broadly comprising," "comprising," "consisting essentially of," or "consisting of" in some embodiments. In this disclosure, any defined meanings do not necessarily exclude ordinary and customary meanings in some embodiments. In some cases, percentages indicate herein can be relative or absolute percentages.

A number of example materials are given throughout the embodiments of the current disclosure, it should be noted that the chemical formulas given for each of the example materials should not be construed as limiting and that the non-limiting example materials given should not be limited by a given example stoichiometry.

In the specification, it will be understood that the term "on" or "over" may be used to describe a relative location relationship. Another element, film or layer may be directly on a mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly to this, it will be understood the term "under", "underlying", or "below" will be construed to be relative concepts.

Referring to FIG. 1, a wafer boat 101 according to embodiments of the present invention is shown. The wafer boat 101 comprises a top member 102 and a bottom member 103. The top member 102 and bottom member 103 may be generally circular in shape. The top member 102 may comprise a circular cut-out centred on a central, vertical axis A of the boat 101. The cut-out may allow for the mass of the boat 101 to be reduced. The top member 102 and the bottom member 103 are spaced apart from each other along the central axis A of the boat 101 and centred on the central axis A.

The boat 101 comprises a first side rod 104, a second side rod 105, and at least one back rod 106. The first side rod 104, the second side rod 105, and the at least one back rod 106 each extend between the top member 102 and the bottom member 103. The rods 104, 105, 106 may be spaced apart circumferentially at a radius slightly displaced inwards from the outer edges (facing away from the central axis A) of the top member 102 and bottom member 103. The first side rod 104 and the second side rod 105 may be spaced apart from the back rod 106 by substantially the same circumferential distance and in opposite directions. That is, an angle subtended by the first side rod 104 and the back rod 106 at the central axis A in a plane perpendicular to the central axis A may be substantially the same as an angle subtended by the second side rod 105 and the back rod 106 at the central axis in the same plane.

Each of the rods 104, 105, 106 comprises a series of vertically spaced apart supports 107. Each rod may comprise at least 50, at least 100, or at least 150 supports 107. The supports 107 are positioned such that each support 107 on one of the rods 104, 105, 106 is at the same position along the axis A as exactly one support on each of the other of the rods 104, 105, 106, thus forming a corresponding set of supports which provide a support position or slot for a wafer, which may rest on the corresponding set of supports. Each support 107 may extend away from the respective rod 104, 105, 106 in which is it comprised, towards the central axis A. A wafer supported by a corresponding set of supports 107 may be supported such that the centre of the wafer coincides with a point on the central axis A.

The supports 107 each comprise a wafer support surface wafer support surface 108 on which, or on at least part of which, a wafer may rest when placed in the boat 101. The wafer support surface wafer support surface 108 may be oriented substantially perpendicular to the central axis A. The wafer support surface wafer support surface 108 may have an RMS surface roughness of less than 10 nm, less than 5 nm, less than 2 nm, or less than 1 nm. The RMS surface roughness may be measured using a profilometer. The wafer support surface wafer support surface 108 may be polished to achieve such a surface roughness. For example, the boat 101 may be formed of a first material, for example silicon, and coated with a second material, for example silicon carbide, and the boat 101 after coating with the second material may have a surface roughness of more than 1 µm; the wafer support surface wafer support surfaces 108 may subsequently be polished to a required RMS surface roughness which is less than 10 nm, less than 5 nm, less than 2 nm, or less than 1 nm. Surfaces of the boat 101 other than the wafer support surface wafer support surfaces 108 may be left unpolished.

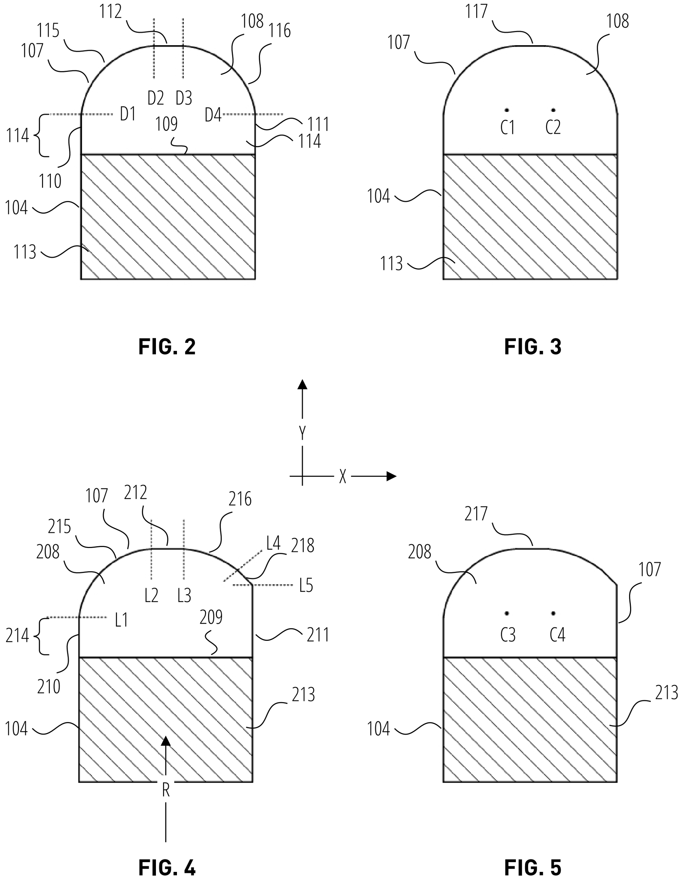

Referring to FIG. 2 and FIG. 3, in which the first side rod 104 is referred to but it is understood that the rod may be the second side rod 105 or the back rod 106, the wafer support surface wafer support surface 108 may be terminated, at least partially, by two rounded corners. The wafer support surface wafer support surface 108 may extend from the rod 104 in a planar manner, being delimited by a back edge 109, first side edge 110, second side edge 111, and front edge 112, each edge being in the same plane. The front edge 112 may be closer to the central axis A than the back edge 109. The back edge 109 may define a boundary between a main body 113 of the first side rod 104 and the support 107. The first side edge 110 and the second side edge 111 may be substantially parallel to each other. The wafer support surface wafer support surface 108 may thus comprise a constant width portion 114 between the front edge 112 and the rod 104.

The front edge 112, delimited by lines L1 and L4 in FIG. 2, may comprise a first rounded corner 115, delimited by lines L1 and L2, and a second rounded corner 116, delimited by lines L3 and L4. The front edge 112 may connect with the first side edge 110 at the first rounded corner 115 and with the second side edge 111 at the second rounded corner 116. The first rounded corner 115 and the second rounded corner 116 may each have the form of a circular arc, each having a respective arc centre located in the plane of the wafer support surface wafer support surface 108. The arc centres C1, C2 may be displaced relative to each other, as seen in FIG. 3. The arc centres may be displaced in a direction parallel to the back edge 109.

The front edge 112 may comprise only the first rounded corner 115 and the second rounded corner 116, that is, the first rounded corner 115 and the second rounded corner 116 may meet directly. The ends of the first rounded corner 115 and the second rounded corner 116 which do not meet each other may meet the first side edge 110 and the second side edge 111 respectively. The front edge 112 may comprise a first straight edge portion 117, delimited by lines L2 and L3. One end of the first straight edge portion 117 may meet an end of the first rounded corner 115 and the other end of the first straight edge portion 117 may meet an end of the second rounded corner 116. The ends of the first rounded corner 115 and second rounded corner 116 which do not meet the first straight edge portion 117 may meet the first side edge 110 and the second side edge 111 respectively.

In some embodiments, the first rounded corner 115 and the second rounded corner 116 may have the same radius of curvature. In some embodiments, the first rounded corner 115 and the second rounded corner 116 may have differing radii of curvature. The radius of curvature of the first rounded corner 115 and/or the second rounded corner 116 may be between 1mm and 15mm, between 2mm and 10mm, between 3mm and 8mm, between 4mm and 6mm. The radius of curvature may be chosen so as to provide a smooth transition along the front edge 112 from the first rounded corner 115, to the optional first straight edge portion 117 and then to the second rounded corner 116.

Referring to FIG. 4 and FIG. 5, in some embodiments, the first side rod 104 and the second side rod 105 may comprise modified wafer support surfaces 208 instead of wafer support surface wafer support surfaces 108. The wafer support surface 208 may extend from the rod 104 in a planar manner, being delimited by a back edge 209, first side edge 210, second side edge 211, and front edge 212, each edge being in the same plane. The front edge 212 may be closer to the central axis A than the back edge 209. The back edge 209 may define a boundary between a main body 213 of the first side rod 104 and the support 107. The first side edge 210 and the second side edge 211 may be substantially parallel to each other. The wafer support surface 208 may thus comprise a constant width portion 214 between the front edge 212 and the rod 104. The constant width portion 214 may have a width of between 10mm and 15mm as measured parallel to the back edge 209.

The front edge 212, delimited by dashed lines L1 and L5 in FIG. 4, may comprise a first rounded corner 215, delimited by dashed lines L1 and L2, and a second rounded corner 216, delimited by dashed lines L3 and L4. The front edge 212 may connect with the first side edge 210 at the first rounded corner 215. The first rounded corner 215 and the second rounded corner 216 may each have the form of a circular arc, each having a respective arc centre located in the plane of the wafer support surface 208. The arc centres C3, C4 may be displaced relative to each other, as seen in FIG. 5. The arc centres may be displaced in a direction parallel to the back edge 209. The arc centres may be displaced relative to each other in a direction parallel to the first side edge 210.

The arcs forming the rounded corners 215, 216 may have different arc lengths. Thus, the wafer support surface 208 may be not symmetrical with respect to reflection about an axis R in the plane of the wafer support surface 208 which bisects the back edge 209.

The front edge 212 may comprise only the first rounded corner 215 and the second rounded corner 216, that is, the first rounded corner 215 and the second rounded corner 216 may meet directly. The ends of the first rounded corner 215 and the second rounded corner 216 which do not meet each other may meet the first side edge 210 and the second side edge 211 respectively. The front edge 212 may comprise a first straight edge portion 217, delimited by lines L2 and L3 and being substantially parallel to the back edge 209. One end of the first straight edge portion 217 may meet an end of the first rounded corner 215 and the other end of the first straight edge portion 217 may meet the second rounded corner 216. The ends of the first rounded corner 215 and second rounded corner 216 which do not meet the first straight edge portion 217 may meet the first side edge 210 and the second side edge 211 respectively.

In some embodiments, the front edge 212 may comprise a second straight edge portion 218, delimited by lines L4 and L5, which meets the second rounded corner 216 at one end of the second straight edge portion 218 and the second side edge 211 at another end of the second straight edge portion 218. Thus, the wafer support surface 208 may be not symmetrical with respect to reflection about an axis R in the plane of the wafer support surface 208 which bisects the back edge 209.

The second rounded corner 216 may have a smaller arc length than the first rounded corner 215. The second rounded corner 216 may have an arc length which is less than 80%, less than 70%, less than 60%, or less than 50% of the arc length of the first rounded corner 215. The second rounded corner 216 may have an arc length which is between 20% and 80%, between 30% and 70%, between 40% and 60% of the arc length of the first rounded corner 215.

The arc lengths and radii of curvature of the rounded corners 215, 216 may be chosen so as to provide a smooth transition along the front edge 212 from the first rounded corner 215, to the optional first straight edge portion 217 and then to the second rounded corner 216.

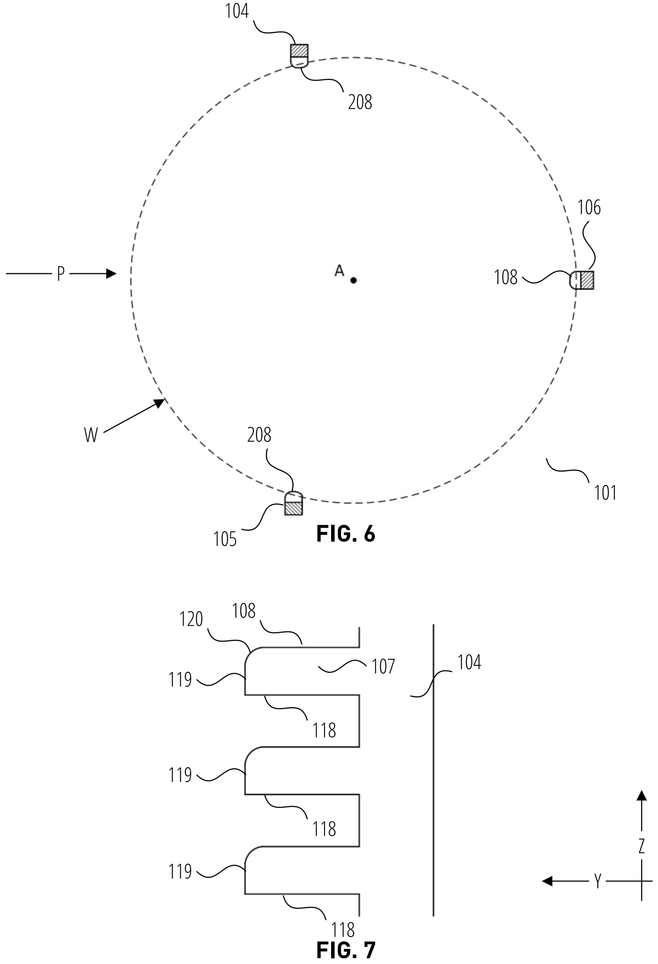

In some embodiments, the first side rod 104 and the second side rod 105 may comprise modified wafer support surfaces 208 as described in relation to FIG. 4 and FIG. 5, and the back rod back rod 106 may comprise a wafer support surface wafer support surface 108 as described in relation to FIG. 2 and FIG. 3. Referring to FIG. 6, a possible arrangement of the first side rod 104, the second side rod 105 and the back rod back rod 106 according to embodiments of the present invention is shown. A wafer W may be inserted into the boat 101 in a wafer insertion direction P and placed such that the wafer W is supported on the support surfaces wafer support surface 108, 208.

Referring to FIG. 7, the supports 107 may each have a bottom face 118 and a side face 119 in addition to the wafer support surface wafer support surface 108, 208. The side face 119 may meet the wafer support surface wafer support surface 108, 208 at a top edge 120. The top edge 120 may be rounded off. The top edge 120 may be rounded off such that the wafer support surface wafer support surface 108, 208 transitions smoothly to the side face 119. The top edge 120 may have a radius of curvature of between 0.5mm and 10mm. By providing a rounded top edge 120 rather than a sharp right angled top edge 120, potential damage to the wafer by the top edge 120 and/or particle formation at the top edge 120 can be reduced or avoided. A radius of curvature from the rounded off edge to the wafer support surface may be larger than the radius of curvature of the rounded off edge, which may provide a continuous transition from the rounded off edge to the wafer support surface.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

## Claims

1. A wafer boat comprising two side rods and at least one back rod, the rods extending substantially vertically between a top member and a bottom member, the rods comprising vertically spaced apart support formed at corresponding heights, each support extending away from the respective boat rods towards a central axis of the wafer boat, wherein each support has a wafer support surface for contacting a wafer, the wafer support surface being a polished surface, and wherein each wafer support surface is terminated by two rounded corners.

2. The wafer boat of claim 1, wherein the wafer support surface comprises a constant width portion between the rounded corners and the respective boat rod.

3. The wafer boat of claim 1 or 2, wherein the rounded corners of the wafer support surfaces of the side rods are each formed by an arc, wherein the two arcs have different arc lengths.

4. The wafer boat of claim 3, wherein one of the arc lengths is between 30% and 70% of the other arc length.

5. The wafer boat of claim 3 or 4, wherein the rounded corner having the smaller arc length connects to a straight edge portion at a side edge of the support, wherein the straight edge portion is at an angle to the edge of the constant width portion.

6. The wafer boat of any one of claims 1 to 5, wherein the centres of the two arcs are displaced relative to each other.

7. The wafer boat of any one of claims 1 to 6, wherein the rounded corners are connected to each other by a straight portion at a front edge of the support.

8. The wafer boat of any one of claims 1 to 6, wherein the rounded corners meet directly at a front edge of the support.

9. The wafer boat of any one of claims 1 to 8, wherein the rounded corners have substantially the same radius of curvature.

10. The wafer boat of claim 9, wherein the radius of curvature is between 1mm and 15mm.

11. The wafer boat of claim 9, wherein the radius of curvature is between 3mm and 8mm.

12. The wafer boat of any one of claims 1 to 11, wherein the wafer support surface extends from the rod in a planar manner, being delimited by a back edge, first and second side edges, and front edge, each edge being in the same plane and the front edge being closer to the central axis of the boat than the back edge is, wherein the wafer support surface is not symmetrical with respect to reflection about an axis in the plane of the wafer support surface, the axis bisecting the back edge.

13. The wafer boat of any one of claims 1 to 12, wherein the wafer support surface has a root-mean-square roughness of less than 1nm.

14. The wafer boat of any one of claims 1 to 13, wherein surfaces of the boat other than the wafer support surface have a root mean square roughness of more than 1 µm.

15. The wafer boat of any one of claims 1 to 14, wherein the wafer support surface has an edge which is rounded off.

16. The wafer boat of any one of claims 1 to 15, wherein the rounded off edge has a radius of curvature of between 0.5 mm and 10 mm.

17. The wafer boat of claim 15 or 16, wherein a radius of curvature from the rounded off edge to the wafer support surface is larger than the radius of curvature of the rounded off edge.

18. The wafer boat of any one of claims 1 to 16, comprising silicon, silicon carbide, and/or quartz.
